**Europäisches Patentamt**

**European Patent Office**

**Office européen des brevets**

(19)

(11) Veröffentlichungsnummer: **0 018 439**
**B1**

(12)

# EUROPÄISCHE PATENTSCHRIFT

(45) Veröffentlichungstag der Patentschrift:
**18.08.82**

(51) Int. Cl.³: **H 05 K 5/02,** B 65 D 25/28

(21) Anmeldenummer: **79105147.7**

(22) Anmeldetag: **13.12.79**

(54) **Drehgriff für quaderförmige Gehäuse.**

(30) Priorität: **27.04.79 DE 2917225**

(43) Veröffentlichungstag der Anmeldung:
**12.11.80 Patentblatt 80/23**

(45) Bekanntmachung des Hinweises auf die Patenterteilung:
**18.08.82 Patentblatt 82/33**

(84) Benannte Vertragsstaaten:
**AT BE CH FR IT NL**

(56) Entgegenhaltungen:
**FR-A-2 176 407**
**GB-A-485 630**

(73) Patentinhaber: **SIEMENS AKTIENGESELLSCHAFT**
**Berlin und München, Postfach 22 02 61,**
**D-8000 München 22 (DE)**

(72) Erfinder: **Engel, Albert, Akilindastrasse 52,**
**D-8032 Gräfelfing (DE)**

## Drehgriff für quaderförmige Gehäuse

Die Erfindung betrifft ein quaderförmiges Gehäuse mit Drehgriffen zur Aufnahme elektrischer Schaltungselemente.

Quaderförmige tragbare Gehäuse sind bisher mit handelsüblichen ausklappbaren Griffen versehen, die meistens eine Gerätevergrösserung mit sich bringen oder durch Anbringen von Griffmulden in den Seitenwänden bündig mit der Baugruppe abgeschossen sind. Dadurch wird jedoch das Tragen durch zwei Personen erschwert.

Aufgabe der vorliegenden Erfindung ist es, einen Griff für ein tragbares Gerät mit rechtwinkligen Aussenkonturen zu schaffen, der sowohl eine einwandfreie Funktion erfüllen soll und der zugleich das Befreien positiv beeinflussen soll.

Zur Lösung dieser Aufgabe wird das Gehäuse gemäss der Erfindung derart ausgebildet, dass es an zwei gegenüberliegenden Kanten einer Gehäuseseite je eine Aussparung aufweist, die sich in diese Gehäuseseite und die jeweils angrenzende Gehäuseseite hinein erstreckt, dass sich über jede dieser Aussparungen parallel zur Gehäusekante eine Drehachse erstreckt, die zu beiden Seiten der Aussparung am Gehäuse gelagert ist, und dass an jeder Drehachse ein Blechteil starr befestigt ist, das so gebogen ist, dass es teilweise die Längsseiten eines quadratischen Quaders bildet, wobei die beiden an der Drehachse anliegenden Blechseiten je eine volle Quaderseite bilden, während die an diese beiden Blechseiten angrenzenden Blechseiten nur einen Teil der betreffenden Quaderseite bilden.

Durch diese Massnahmen erhält man einen Griff, der sich, wenn er nicht benutzt wird, formschlüssig in das Gehäuse einfügt, der jedoch bei Benutzung in einfacher Weise zurück- oder hochgeklappt werden kann, so dass sowohl eine als auch zwei Personen das Gerät leicht tragen können. Nach Gebrauch wird die Klappe in die Ausgangslage zurückgeführt.

Anhand der Ausführungsbeispiele nach den Fig. 1 bis 3 wird die Erfindung näher erläutert. Es zeigen:

Fig. 1 den Drehgriff in eingeklappter Lage,

Fig. 2 den Drehgriff so ausgeklappt, dass das Gehäuse von einer Person getragen werden kann,

Fig. 3 den Drehgriff so ausgeklappt, dass das Gehäuse von zwei Personen getragen werden kann.

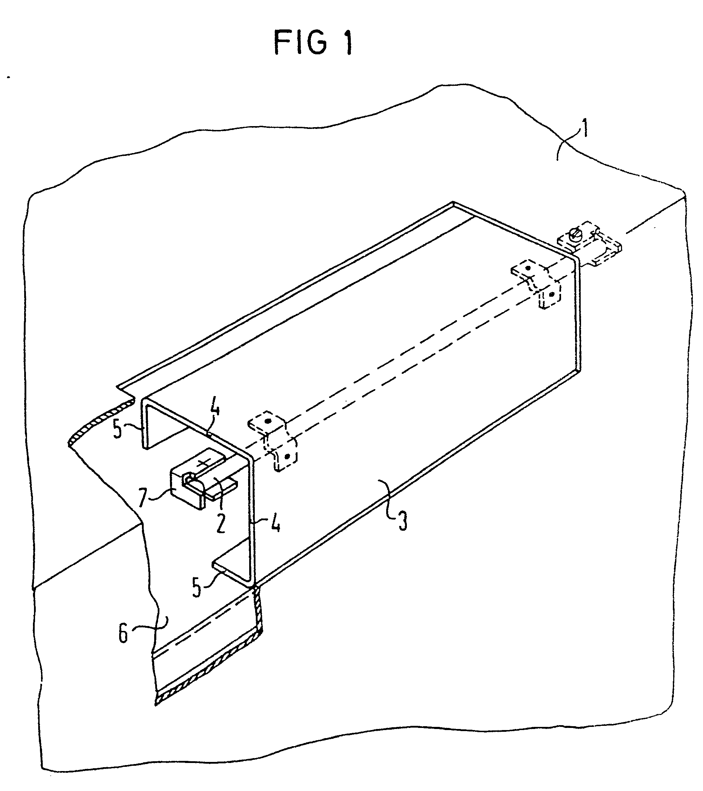

Das quaderförmige Gehäuse 1 nach Fig. 1 ist auf zwei gegenüberliegenden Karten einer Seite mit einer Aussparung 6 versehen. In der Verlängerung der Kanten ist dabei eine Achse 2 in den Lagern 7 drehbar gelagert. Auf der Achse ist ein mehrfach gebogenes Blechteil 3 befestigt, wobei das Blechteil so gebogen ist, dass es einen quadratischen Querschnitt hat, wobei jedoch nur die beiden Seiten dieses quadratischen Querschnitts voll vorhanden sind, während die beiden diesen Seiten 4 benachbarten Seiten 5 nur teilweise vorhanden sind.

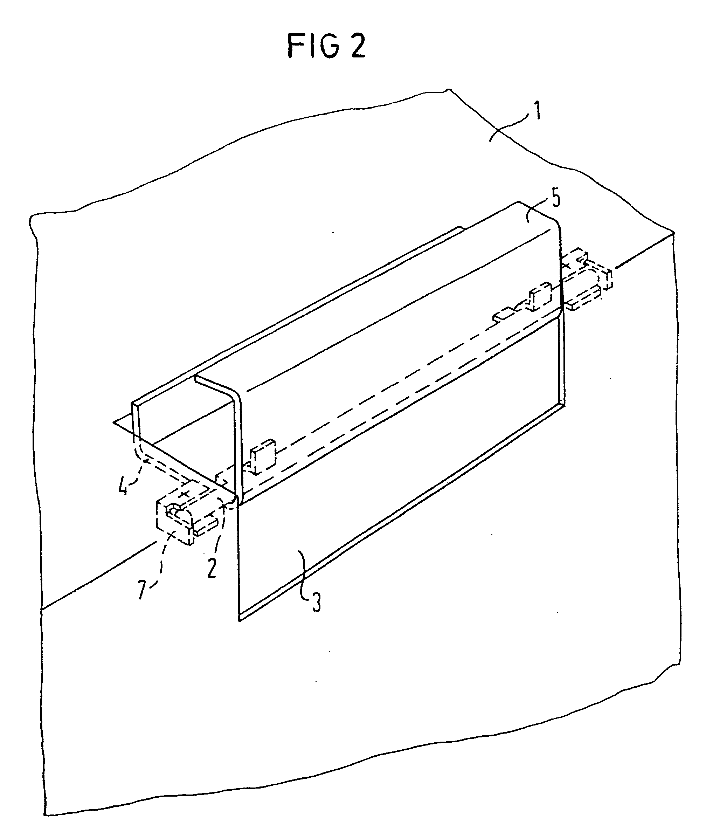

Dreht man nun diesen Drehgriff um die Achse 2 nach rechts, so entsteht ein Traggriff, der nach aussen gebogen ist, so dass das Gehäuse bequem von einer Person getragen werden kann. (Fig. 2)

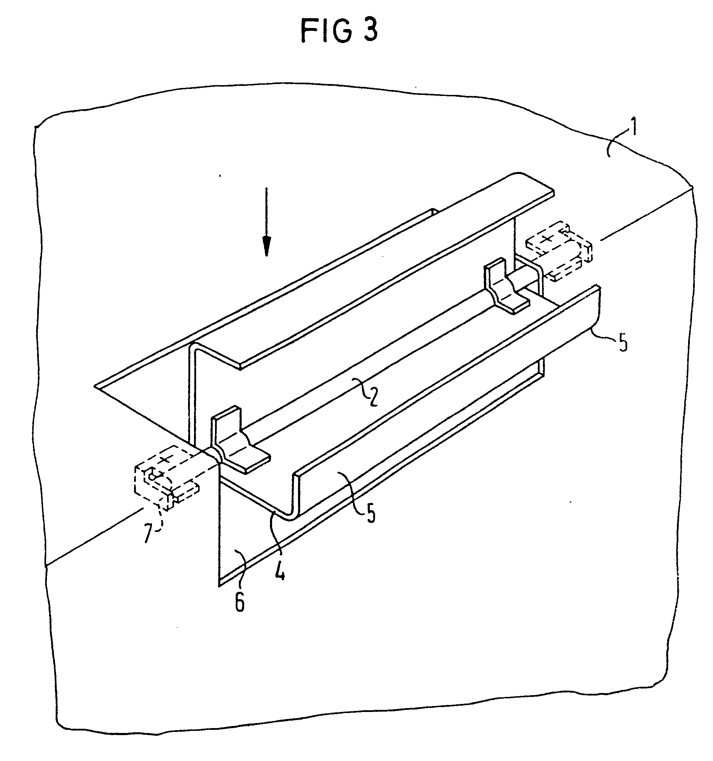

Dreht man den Traggriff nach links, so zeigt das Biegeteil 5 nach innen. Nunmehr kann dieses Gerät von zwei Personen leicht getragen werden. (Fig. 3)

**Patentanspruch**

Quarderförmiges Gehäuse mit Drehgriffen zur Aufnahme elektrischer Schaltungselemente, dadurch gekennzeichnet, dass das Gehäuse an zwei gegenüberliegenden Kanten einer Gehäuseseite je eine Aussparung (6) aufweist, die sich in diese Gehäuseseite und die jeweils angrenzende Gehäuseseite hinein erstreckt, dass sich über dieser Aussparungen parallel zur Gehäusekante eine Drehachse (2) erstreckt, die zu beiden Seiten der Aussparung am Gehäuse gelagert ist, und dass an jeder Drehachse ein Blechteil (3) starr befestigt ist, das so gebogen ist, dass es teilweise die Längsseiten eines quadratischen Quaders bildet, wobei die beiden an der Drehachse anliegenden Blechseiten (4) je eine volle Quaderseite bilden, während die an diese beiden Blechseiten angrenzenden Blechseiten (5) nur einen Teil der betreffenden Quaderseite bilden.

**Revendication**

Boîtier parallélépipédique à poignées tournantes, destiné à recevoir des éléments de montage électriques, caractérisé par le fait que sur chacun des deux bords opposés d'un côté du boîtier, ce dernier comporte une ouverture (6) qui s'étend dans ce côté du boîtier et dans le côté du boîtier voisin, et qu'au-dessus de chacune de ces ouvertures et parallèlement aux bords du boîtier s'étend un axe de rotation (2) qui est monté sur le boîtier, de part et d'autre de l'ouverture, et qu'à chaque axe de rotation est solidarisé un élément en tôle (3) qui est plié de telle façon qu'il forme partiellement les côtés longitudinaux d'un parallélépipède à base carrée, les côtés de la tôle (4) qui sont voisins de l'axe de rotation formant chacun un plein côté du parallélépipède, alors que les côtés de tôle (5) qui sont voisins des précédents ne forment qu'une partie du côté correspondant du parallélépipède.

## Claim

A housing for the reception of circuit elements of parallelepiped shape and having rotatable handles, characterised in that at two oppositely located edges of one side of the housing, the housing is provided with a respective recess (6) which extends into this side of the housing and into the adjoining side thereof; that an axle (2) extends across each recess parallel to the edge of the housing, the axle being supported in the housing at both sides of the recess; and that a sheet metal part (3), which is bent so that it forms part of the longitudinal sides of a square-section parallelepiped, is rigidly secured to each axle, the two sheet metal sides (4) attached to the axle each forming a full side of the parallelepiped, whilst the sheet metal sides (5) which adjoin said two sheet metal sides (4) only form a part of a respective side of the parallelepiped.

# FIG 1

# FIG 2

# FIG 3